# EUROPEAN PATENT SPECIFICATION

(11) **EP 3 184 664 B1**
(45) Date of publication and mention of the grant of the patent: **10.04.2019**
(21) Application number: 15833903.6
(22) Date of filing: 07.08.2015
(51) Int. Cl.: C23C 14/34, C23C 14/52, G01N 27/62, H01J 37/34, H01J 37/32

(54) **METHOD AND DEVICE FOR SPUTTERED PARTICLE MEASUREMENT**
VERFAHREN UND VORRICHTUNG ZUR SPUTTERPARTIKELMESSUNG
PROCÉDÉ ET DISPOSITIF DE MESURE DE PARTICULES PULVÉRISÉES

(30) Priority: 19.08.2014 JP 2014166410
(43) Date of publication of application: 28.06.2017
(73) Proprietor: Ayabo Corporation, Anjo-shi, Aichi 446-0052 (JP); Tohoku University, Sendai-shi, Miyagi 980-8577 (JP)
(72) Inventor: TSUKAMOTO, Keizo, Anjo-shi Aichi 446-0052 (JP); TONA, Masahide, Anjo-shi Aichi 446-0052 (JP); MISAIZU, Fuminori, Sendai-shi Miyagi 980-8577 (JP); KOYASU, Kiichirou, Tokyo 113-0033 (JP)
(74) Representative: Garavelli, Paolo
(86) International application number: PCT/JP2015/072444
(87) International publication number: WO 2016/027691

(56) References cited:
- JP-A- 2011 232 071
- JP-A- 2012 099 226
- JP-A- 2012 099 226
- US-A1- 2009 200 461
- HIRONORI TSUNOYAMA ET AL: "Development of High-flux Ion Source for Size-selected Nanocluster Ions Based on High-power Impulse Magnetron Sputtering", CHEMISTRY LETTERS, vol. 42, no. 8, 5 August 2013 (2013-08-05) , pages 857-859, XP055457034, JAPAN ISSN: 0366-7022, DOI: 10.1246/cl.130247
- EHIASARIAN A ET AL: "Ion composition produced by high power impulse magnetron sputtering discharges near the substrate", JOURNAL OF APPLIED PHYSICS, AMERICAN INSTITUTE OF PHYSICS, US, vol. 104, no. 8, 27 October 2008 (2008-10-27), pages 83305-83305, XP012117877, ISSN: 0021-8979, DOI: 10.1063/1.3000446

## Description

### [Technical field]

The present invention specifically relates to a method and a device for instantly measuring the kind and intensity of sputtered particles discharged by a pulse sputtering method or specifically by a high power impulse magnetron sputtering method.

### [Background art]

The high power impulse magnetron sputtering method (which will be abbreviated as "HIPIMS (High Power Impulse Magnetron Sputtering)" hereafter) is one of the methods for discharging particles from a target as described above. The HIPIMS is expected as a sputtering technology with high performance and high efficiency (see patent documents 1 and 2). A sputtering source of the HIPIMS applies pulses of a high voltage to a target such as a sputtering metal placed in an inert gas such as Ar (argon), thereby sputtering particles (ion particles and neutral particles), that is, causing impact detachment of the particles, from the target.

### [Prior art documents]

### [Patent documents]

[Patent document 1] JP-A-2010-512458
[Patent document 2] JP-A-2010-512459

### [Summary of invention]

### [Problems to be solved by invention]

The HIPIMS can generate a high-temperature and high-density plasma and can provide a higher degree of ionization than the conventional RF method or the DC magnetron sputtering method. Therefore, it is expected that use of the HIPIMS results in film formation with higher quality than the conventional technologies. However, in terms of industry, the HIPIMS is on the way of development regarding its use, concrete use conditions and the like.

In the film formation using the HIPIMS, in order to form a vapor-deposited film with aimed specifications, it is desirable to clarify factors that affect the film formation and to control the factors with high accuracy. Usually, an oxide film and extraneous substances exist on a surface of a work, on which the vapor-deposited film is to be formed. Therefore, before performing the vapor deposition using the sputtering, the work surface may be etched to remove the oxide film and the extraneous substances therefrom, thereby improving the quality of adhesion of the vapor-deposited film to the work and improving the quality of the vapor-deposited film. When performing the sputtering etching using the HIPIMS, in order to perform the etching with aimed specifications, it is desirable to clarify factors that affect the etching and to control the factors with high accuracy. JP-A-2012 099226 discloses a sputtered particle measuring device, wherein ions, which are contained in the plasma generated from the sputtering source of a HIPIMS, are subjected to TOF mass spectroscopy, and the ions' distribution is measured. The time of flight measurement is triggered by detection of the plasma light.

It is therefore an object of the present invention to provide a method and a device capable of accurately measuring sputtered particles (ion particles and neutral particles) discharged by a sputtering method. Specifically, it is an object of the present invention to provide a method and a device capable of instantly measuring the kind and intensity of sputtered particles discharged by a pulse sputtering method or specifically by the HIPIMS. Thus, for instance, factors affecting film formation or etching using the sputtering method or specifically the HIPIMS can be grasped, and the film formation or the etching can be controlled with high accuracy and in real time based on the grasped factors. Moreover, advantages similar to the above-mentioned advantages can be obtained if the discharged particles (ion particles and neutral particles) can be measured with high accuracy not only in the case where the particles are discharged from the target by the sputtering method but also in the case where the particles are discharged from the target by a method such as an arc discharge method or a laser ablation method.

### [Means for solving problems]

To solve the above problems, the inventors of the present invention studied hard and reached following aspects. That is, a sputtered particle measuring device according to any one of claims 1-6.

The ratio between the number of the ion particles and the number of the neutral particles discharged (or sputtered) from the target by the sputtering is considered to be one of factors affecting not only the quality of the vapor-deposited film but also a film formation rate or an etching rate. Therefore, with the measuring device according to the above aspect, one of the factors affecting the film formation or the etching using the sputtering such as the HIPIMS can be grasped.

In the time-of-flight mass spectrometry using the TOFMS (Time-of-Flight mass spectrometer), ions as the analysis object are accelerated by a static electric field. At that time, the same energy is given to every ion. Accordingly, light ions have high speed, and heavy ions have low speed. By using this principle, the time (time of flight) since the acceleration is started until the ion reaches a detector after the ion flies through an inside of a flight tube is measured, thereby obtaining a mass spectrum.

With the configuration according to the above aspect, the ions discharged from the target are accelerated by the static electric field and the mass spectrum is obtained by the time-of-flight measurement. From the mass spectrum, the kind of the produced ion particles and the equivalent value of the number of the produced ion particles can be obtained. As for the neutral particles discharged from the target, the neutral particles may be ionized by the ionizing section and accelerated by the static electric field likewise, whereby the kind of the produced ion particles can be observed and the equivalent value of the number thereof can be measured.

It was found by the experiments conducted by the inventors that, if the ion particles and the neutral particles produced by the same pulsed electric discharge are the detection objects of the TOFMS at the same time and potential fluctuation of an electron amplification detector anode is observed on an oscilloscope, a deviation occurs in positions of potential peaks, which indicate the times of arrival to the detection electrode, between the ion particles discharged from the target by the sputtering in the form of the ions from the beginning and the ion particles that originate from the neutral particles and that are discharged by the sputtering in the form of the neutral particles and that are ionized by the ionizing section. That is, the obtained result showed that the ion particles that are discharged in the form of the ions from the beginning have the shorter time of flight than the ion particles originating from the neutral particles. The cause thereof is thought to be that the ion particles discharged in the form of the ions from the beginning have higher speed than speed of the neutral particles in the acceleration area. Therefore, with the above scheme, the equivalent value of the number of the ion particles and the equivalent value of the number of the neutral particles discharged by the sputtering caused by the single pulsed electric discharge can be measured at the same time.

With the construction of any one of claims 1-6, at respective timings when the sputtering is performed, both of timings for driving the ionizing section and timings not for driving the ionizing section can be defined. Through the measurement at the timing for driving the ionizing section, the sum total of the equivalent value of the number of the ion particles discharged in the form of the ions by the sputtering and the equivalent value of the number of the ion particles that are discharged in the form of the neutral particles and ionized by the ionizing section is measured. At the timing when the ionizing section is not driven, the neutral particles are not ionized, so only the equivalent value of the number of the ion particles discharged in the form of the ions by the sputtering is measured through the measurement at such timing. Thus, only with the two timings at the minimum, the equivalent values can be obtained for the respective kinds of the sputtered particles of the ion particles and the neutral particles (in this case, equivalent value of number of neutral particles can be obtained by subtraction). Thus, the measurement within the very short time can be realized under substantially the same conditions.

Experiments conducted by the inventors showed that, by setting the period of the frequency dividing signal in a given range, significant values as the equivalent values of the number of the ion particles and the number of the neutral particles to be compared with each other can be obtained.

With the construction of any one of claims 1-6, the measurement of the ratio can be performed within a very short time under substantially the same conditions, and only the equivalent values of the numbers of the respective kinds of the neutral particles discharged from the target by the sputtering can be measured respectively while removing the ion particles.

With the construction of any one of claims 1-6, when the ionizing section is driven in the state where the ion particles are removed by the ion particle removing section, only the ion particles originating from the neutral particles can be used as the measurement object. Thus, the kind of the neutral particle can be observed with high precision and the equivalent value of the number of the neutral particles can be measured with high accuracy.

A sputtering device according to claim 7 is a sputtering device using the HIPIMS.

There is a tendency that the ratio of the number of the ion particles discharged from the target to the number of the neutral particles discharged from the target increases as the current amount, the voltage value or the electric energy for the discharge during each pulsed electric discharge of the HIPMS increases. Therefore, feedback control of the ratio of the equivalent values can be performed by controlling the current amount, the voltage value or the electric energy for each pulsed electric discharge based on the ratio of the equivalent values measured with the measuring device.

In addition, there is a tendency that the etching of the work is promoted as the absolute value of the bias voltage (negative voltage) applied to the work increases. There is a tendency that the deposition on the work (i.e., film formation) is promoted as the absolute value of the bias voltage decreases. Therefore, by controlling the bias voltage applied to the work based on the ratio of the equivalent values measured with the measuring device, the film formation and the etching can be controlled with high accuracy.

By using either or both of such control schemes, the film formation and the etching can be controlled with high accuracy based on the actual state of the production of the ion particles and the neutral particles from the target.

### [Brief explanation of drawings]

Embodiments, including embodiments of the invention, will now be described, by way of example only, with reference to the accompanying schematic drawings in which corresponding reference symbols indicate corresponding parts, and in which:
Fig. 1 is a view schematically showing a sputtered particle measuring device according to a first embodiment.
Fig. 2 is a diagram of a pulse train for illustrating a measurement example using the sputtered particle measuring device according to the first embodiment.
Fig. 3 is a spectrum example obtained by the measurement using the sputtered particle measuring device according to the first embodiment.
Figs. 4A and 4B are characteristic diagrams for controlling film formation and etching using the sputtered particle measuring device according to the first embodiment.
Fig. 5 is a partial enlarged diagram showing a spectrum obtained by a sputtering device.
Fig. 6 is a diagram schematically showing a sputtered particle measuring device according to a second embodiment.
Fig. 7 is a diagram of a pulse train for illustrating a measurement example using the sputtered particle measuring device according to the second embodiment.
Fig. 8 is a diagram schematically showing a sputtered particle measuring device according to a third embodiment.
Fig. 9 is a diagram of a pulse train for illustrating a measurement example using the sputtered particle measuring device according to the third embodiment.
Fig. 10 is a diagram schematically showing a sputtered particle measuring device according to a fourth embodiment.
Fig. 11 is a diagram showing an operation of a shutter of the sputtered particle measuring device according to the fourth embodiment.
Fig. 12 is a diagram of a pulse train for illustrating a measurement example using the sputtered particle measuring device according to the fourth embodiment.
Fig. 13 is a diagram of a pulse train for illustrating a sputtered particle measurement example according to a fifth embodiment.

### [Embodiments]

### (First embodiment)

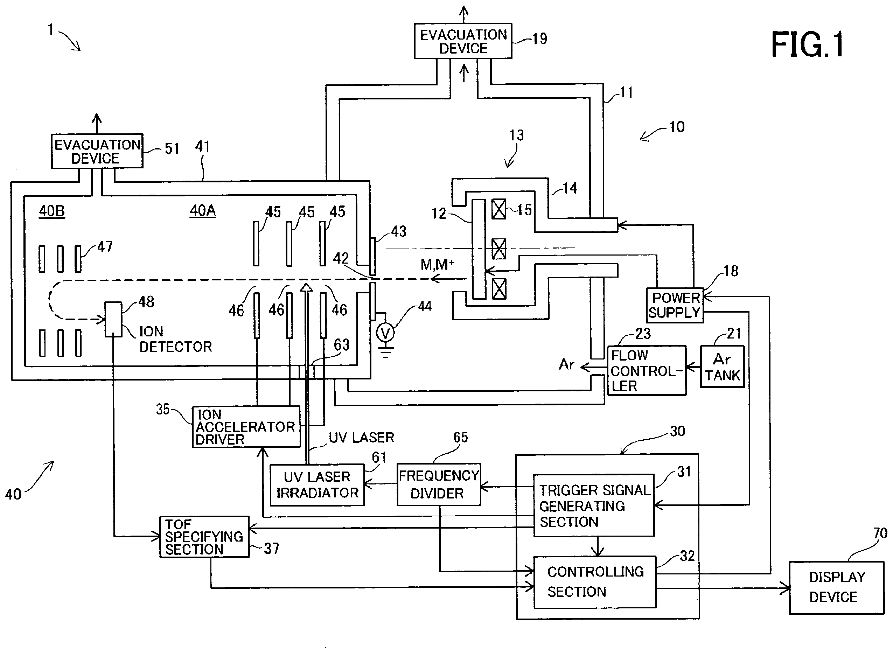

Hereafter, a first embodiment will be explained. Fig. 1 is a conceptual diagram showing a construction of a sputtered particle measuring device 1 according to a first embodiment. The sputtered particle measuring device 1 of the present embodiment has a HIPIMS section 10, a controller 30 and a TOF mass spectrometry section 40 as main components. The HIPIMS section 10 has a chamber 11, a sputtering source 13 and an evacuation device 19. The sputtering source 13 has a target 12 (for instance, metallic target), an anode electrode 14 and a magnet unit 15. The target 12 is connected to a power supply 18 as a cathode electrode. A space inside the chamber 11 is once evacuated with the evacuation device 19 consisting of a turbo molecular pump or the like to a predetermined degree of vacuum (for instance, 10⁻⁴ Pa). Then, an argon gas as a sputtering gas is introduced into the space inside the chamber 11, and the space inside the chamber 11 is maintained at approximately 1×10⁻² Pa to approximately 1 Pa. The reference numeral 21 denotes an argon gas tank. A flow of the argon gas is controlled by a flow controller 23. A reactive gas such as nitrogen may be mixed into the argon gas.

If the argon gas is supplied into the chamber 11 and a pulsed electric power is supplied from the power supply 18 to the sputtering source 13 (that is, for instance, if high voltage of approximately 1 kV in the shape of pulse of 10 microseconds to 2000 microseconds is applied between target 12 and anode electrode 14), a pulsed glow discharge arises between the target 12 and the anode electrode 14, and a pulsed plasma originating from the argon is formed near the target 12. The HIPIMS section 10 according to the present embodiment can perform magnetron sputtering by forming a magnetic field near the surface of the target 12 using the magnet unit 15 and can generate a comparatively strong glow discharge. As a result, neutral particles and ions (monovalent ions and multivalent ions) of the material forming the target are discharged from the target 12.

The controller 30 has a trigger signal generating section 31 and a controlling section 32. Every time the high-voltage pulse is applied from the power supply 18 to the sputtering source 13, a pulse signal synchronized with that timing is outputted from the power supply 18 to the trigger signal generating section 31 of the controller 30. The trigger signal generating section 31 generates trigger signals synchronized with the pulse signal and outputs the trigger signals to an ion accelerator driver 35, a TOF (i.e., time of flight) specifying section 37 and a frequency divider 65 of the TOF mass spectrometry section 40.

The TOF mass spectrometry section 40 further has a casing 41, a gate 43 consisting of a metal plate, an ion accelerator 45, an ion detector 48 and a UV laser irradiator 61. The present embodiment uses a reflectron TOF mass spectrometry section 40 having a reflectron 47. An inside of the casing 41 is partitioned into a first chamber 40A and a second chamber 40B. The ion accelerator 45 is arranged in the first chamber 40A. The reflectron 47 and the ion detector 48 are arranged in the second chamber 40B. The casing 41 is fixed to the chamber 11 of the HIPIMS section 10. The casing 41 faces the sputtering source 13 of the HIPIMS section 10 and opens to the sputtering source 13 through an aperture 42. The aperture 42 is made by boring a hole having the diameter of, for instance, approximately 1 mm in the gate 43.

It is necessary to maintain the pressure inside the casing 41 of the TOF mass spectrometry section 40 to be lower than the pressure inside the chamber 11 of the HIPIMS section 10. Therefore, it is desirable to make the aperture 42, which serves as an interface therebetween, as small as possible. At the same time, it is necessary to stably introduce the ions and the neutral particles, which have been produced in the chamber 11, into the TOF mass spectrometry section 40. In order to do so, it is desirable to make the diameter of the aperture 42 large. It is desirable to set the diameter of the aperture 42, which has such a trade-off, in a range from 0.1 mm to 5 mm according to the study performed by the inventors.

The gate 43 can be switched between a state where the gate 43 is earthed to the ground (Gnd) and a state where the gate 43 is at a predetermined potential by a potential changing circuit 44. In the TOF mass spectrometry section 40 used for grasping the state of the sputtering, the ions can be introduced into the casing 41 by setting the potential of the gate 43, which serves as an ion introduction hole to the TOF mass spectrometry section 40, to be equal to or lower than the ground potential.

The gate 43 can be made to function as a prevention electrode by maintaining the potential of the gate 43 to a plasma potential using the potential changing circuit 44. The plasma potential is a predetermined potential equal to or higher than a potential exceeding an energy, which the ion can have. For instance, the predetermined potential is a potential Vg higher than approximately 20V. Thus, the ions can be prevented from entering the casing 41 through the aperture 42. In this case, only the neutral particles can pass through the aperture 42 and enter the inside of the casing 41. Thus, the object of the analysis by the TOF mass spectrometry section 40 can be limited to the ion particles originating from the neutral particles.

The aperture 42 is deviated outward from the center of the target 12. In the present embodiment, the aperture 42 is decentered by 22.5 mm to sample a portion having the highest concentration of the sputtered particle ions. The clearance of 5 cm is provided between the aperture 42 and the target 12 in the present embodiment, but the clearance therebetween may be set arbitrarily. The ion accelerator 45 provided in the first chamber 40A consists of multiple metal plates having openings 46 on the same axis as the aperture 42. The ion accelerator 45 accelerates the ions that pass through the openings 46. Metal meshes may be attached to the openings 46 to rectify distortion of an electric field. A fixed high voltage Va (1.4 kV in this example) is applied from the ion accelerator driver 35 to the ion accelerator 45. The accelerated ion is reflected by the reflectron 47 and is detected with the ion detector 48 consisting of a MCP detector, for instance. A time since the occurrence of the trigger signal to the detection of the ion is specified as a time of flight (that is, TOF) with the TOF specifying section 37. A kinetic energy 1/2mv² given from the ion accelerator 45 is constant. Therefore, difference in the mass (m) of the ion is detected as the difference in the speed (v), or the time for the ion to reach the ion detector 48. The lighter the ion is, the higher the speed is. The heavier the ion is, the lower the speed is. The detection result is outputted from the TOF specifying section 37 to the controlling section 32 of the controller 30.

It is desirable to provide an evacuation device 51 also in the TOF mass spectrometry section 40 and to perform evacuation (differential evacuation) separately from the HIPIMS section 10, thereby discharging the argon gas from the inside of the TOF mass spectrometry section 40. In the present embodiment, the degree of vacuum in the TOF mass spectrometry section 40 is set at 1×10⁻⁴ Pa in the first chamber 40A and is set at 3×10⁻⁵ Pa in the second chamber 40B.

### (Working Example)

Next, a measuring method of the sputtered particles using the sputtered particle measuring device 1 according to the present embodiment will be explained as a working example. In the working example, it is aimed to discriminate the kinds of the ion particles and the neutral particles, which are sputtered particles sputtered from the target 12 by the pulsed electric discharge of the HIPIMS, to grasp both of an equivalent value of the number of the ion particles and an equivalent value of the number of the sputtered neutral particles in the sputtered particles using the TOF mass spectrometry technique regarding the respective kinds of the sputtered particles, and to grasp the actual state of the sputtering based on a ratio between the equivalent values. In the working example below, a target consisting of a single element metal is used as the target 12, but the present disclosure is not limited to this.

When the ion accelerator driver 35 receives the trigger signal from the trigger signal generating section 31, the ion accelerator driver 35 accelerates the ions by applying a predetermined high voltage Va to the ion acceleration electrodes 45. A time (TOF: Time of Flight) from timing when the acceleration is started to timing when the ion reaches the detector 48 by flying through a flight tube having a fixed distance is measured, and the mass spectrum is obtained. The trigger signal is applied also to the TOF specifying section 37 to determine the start timing of the flight of the ion. An equivalent value (M⁺) correlated with the number of the metal ion particles produced in the HIPIMS section 10 can be obtained from the obtained mass spectrum. The time from the ion acceleration start to the detection is very short time of tens to hundreds of microseconds.

The metal neutral particles discharged from the target 12 by the pulsed electric discharge in the HIPIMS section 10 enter the inside of the casing 41 through the aperture 42. The UV laser irradiator 61 irradiates the metal neutral particles in the casing 41 with a UV laser through a transmission window 63 provided in the casing 41 and ionizes the metal neutral particles. If the metal neutral particles are ionized, they are brought into the state where they can be accelerated by the ion accelerator 45. In this way, the metal neutral particles can also be made into the object of analysis by the TOF mass spectrometry section 40, and the equivalent value (M) correlated with the number of the metal neutral particles sputtered from the target 12 by the HIPIMS becomes measurable by the TOF mass spectrometry section 40. In this working example, a vacuum UV laser generator as the UV laser irradiator 61 uses the ninth-order harmonic (118 nm, 10.5 eV) of the fundamental wave (1064 nm) of the Nd:YAG laser. Not only the vacuum UV laser generator but also any other ionizing device such as a thermal electron pulse beam generator may be used. In the embodiment, the UV laser is emitted so that it passes through substantially the middle between the two metal plates of the ion acceleration electrode 45.

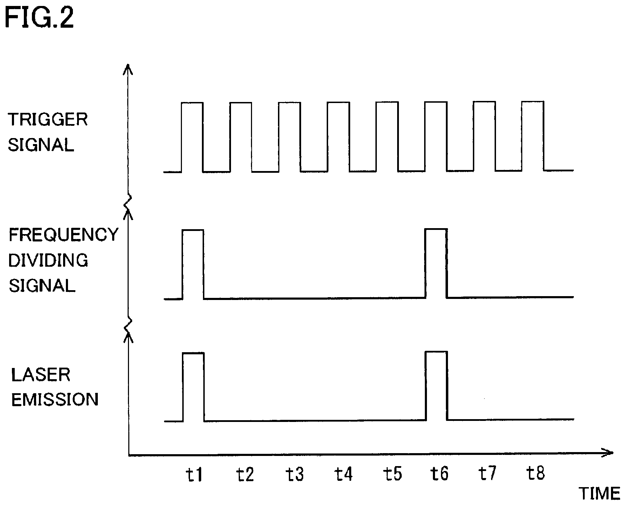

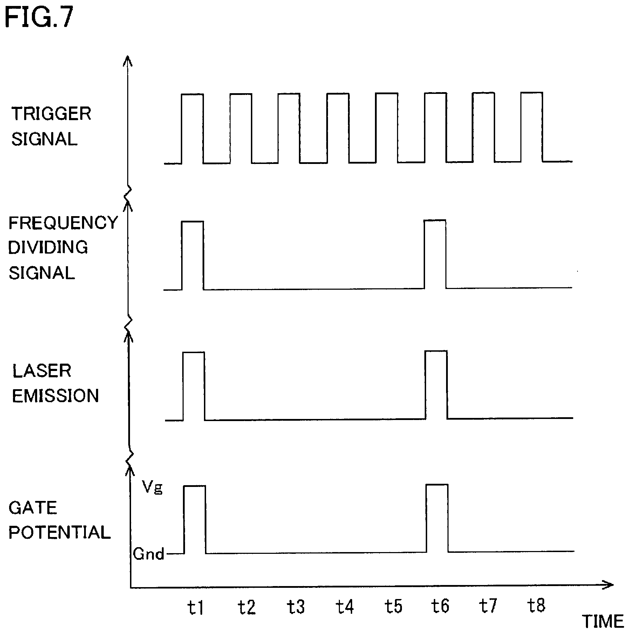

The frequency divider 65 generates a pulsed frequency dividing signal having a period, which is integral multiple of a period of the trigger signal, based on the trigger signal and outputs the frequency dividing signal to the UV laser irradiator 61. The UV laser irradiator 61 emits a UV laser by using the input of the frequency dividing signal as a trigger. Fig. 2 shows an example of a relationship among the trigger signal, the frequency dividing signal and timing of the emission of the UV laser. The horizontal axis in Fig. 2 indicates the time. In this example, the frequency dividing ratio (i.e., ratio between period of trigger signal and period of frequency dividing signal) is set to five. Fig. 2 shows the relationship among the signals, the period and the timing of the laser emission and the like only schematically. Widths of the actual pulses and the relationship among the periods may vary from the example shown in the drawing (this is also true with Figs. 7, 9, 12 and 13 explained later).

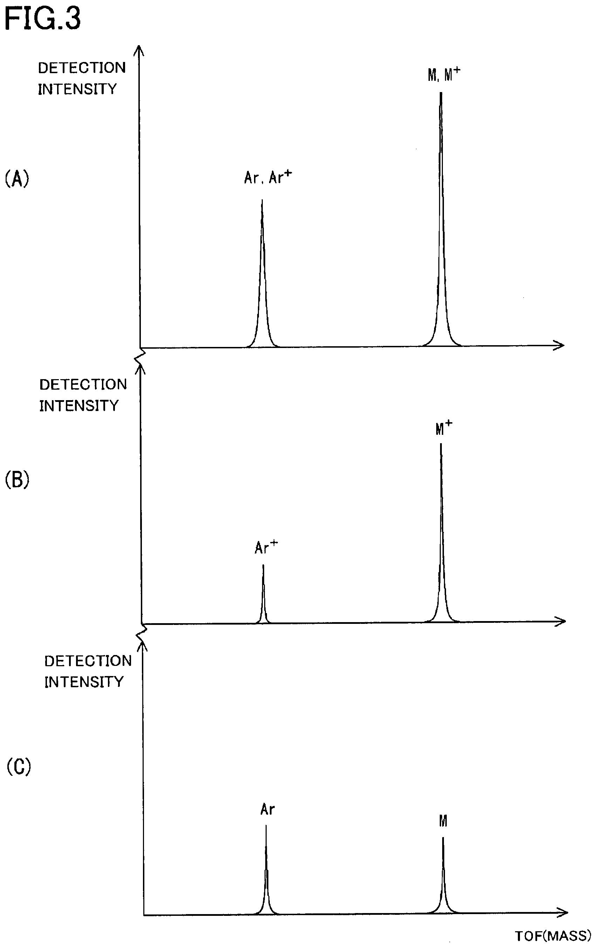

A TOF spectrum obtained with the device according to the above-mentioned embodiment (shown in Fig. 1) is schematically shown in Fig. 3. The measurement conditions are as follows.
Target: Ti
Applied voltage: 600V
Voltage pulse width: 1500 microseconds
Trigger signal frequency: 50 Hz
Ar gas flow: 200ccm
Laser frequency: 10 Hz

Detection intensity of the metal (Ti in this example) in this mass spectrum can be used as the equivalent value (M⁺) of the number of the metal ion particles and the equivalent value (M) of the number of the metal neutral particles, which are discharged from the target 12 by the HIPIMS. Detection intensity of Ar as the sputtering gas is also shown as reference. Fig. 3(A) shows the detection result by the TOF mass spectrometry section 40 at the timing such as timings t1 and t6 in Fig. 2 when both the trigger signal and the frequency dividing signal are emitted and the ionization of the neutral particles is performed by the laser irradiator 61. Fig. 3(B) shows the detection result by the TOF mass spectrometry section 40 at the timing such as timings t2-t5, t7 and t8 in Fig. 2 when only the trigger signal is emitted but the frequency dividing signal is not emitted and the neutral particles are not ionized. Fig. 3 (C) shows a value calculated by subtracting the detection intensity of Fig. 3 (B) from the detection intensity of Fig. 3 (A).

The detection intensity shown in Fig. 3 (A) is a detection result at the time when the pulsed electric discharge of the HIPIMS and the ionization of the neutral metal particles with the UV laser irradiation are performed at the same time. Therefore, both of the metal ion particles produced by the pulsed electric discharge of the HIPIMS and the metal ion particles produced by ionizing the metal neutral particles produced by the pulsed electric discharge are detected by the TOF mass spectrometry section 40. That is, the detection intensity shown in Fig. 3 (A) indicates the sum total of the equivalent value (M⁺) of the number of the metal ion particles discharged from the target 12 by the pulsed electric discharge and the equivalent value (M) of the number of the metal neutral particles discharged from the target 12 by the pulsed electric discharge.

Fig. 3 (B) shows the detection result of the case where the ionization of the metal neutral particles by UV laser irradiation is not performed and only the metal ion particles emitted by the HIPIMS are detected by the TOF mass spectrometry section 40. Therefore, the detection intensity shown in Fig. 3 (B) can be used as the equivalent value (M⁺) of the number of the metal ion particles. Accordingly, it can be regarded that the value shown in Fig. 3 (C) obtained by subtracting the detection intensity shown in Fig. 3 (B) from the detection intensity shown in Fig. 3 (A) is an equivalent value (M) of the number of the neutral metal particles discharged by the pulsed electric discharge of the HIPIMS. Each of the detection values of Fig. 3 (A) and Fig. 3 (B) may be a cumulative value or an average value of the respective values at the multiple pulse timings. In order to calculate the equivalent value (M) of the number of the neutral metal particles of Fig. 3 (C), the subtraction may be performed after equalizing the number of times of the pulses between Fig. 3 (A) and Fig. 3 (B), for instance.

In this way, by generating the frequency dividing signal at the same timing as a part of the trigger signals using the frequency divider 65, the TOF mass spectrometry in the case where both of the pulsed electric discharge of the HIPIMS and the ionization of the neutral metal particles are performed and the TOF mass spectrometry in the case where only the pulsed electric discharge of the HIPIMS is performed but the ionization is not performed can be performed within a very short time. For instance, when the frequency of the trigger signal is 50 Hz, the time length from the timing t1 to the timing t2 is 20 milliseconds, which is very short. The equivalent value of the number of the metal neutral particles and the number of the metal ion particles can be calculated respectively even from only the TOF mass spectrometry results at the time t1 and the time t2 within the very short interval. The output result of the TOF mass spectrometry section 40 can be obtained within hundreds of microseconds. Even if the time for obtaining the output result of the TOF mass spectrometry section 40 is taken into account, the measurement still completes within a short time. In this way, the equivalent values of the number of the metal neutral particles and the number of the metal ion particles can be measured within a very short time, so there is an advantage that both the equivalent values can be measured under substantially the same measurement conditions. According to the experiments conducted by the inventors, it is desirable to set the frequency dividing ratio to an integer from two to ten in order to acquire significant values as the metal ion particle number equivalent value and the metal neutral particle number equivalent value, which are to be compared with each other.

The controlling section 32 receives the trigger signal from the trigger signal generating section 31 and the frequency dividing signal from the frequency divider 65 in addition to the detection result from the TOF specifying section 37. Based on the received trigger signal and frequency dividing signal, the controlling section 32 determines whether the measurement result sent from the TOF specifying section 37 is the measurement result in the case where the laser emission is performed or the measurement result in the case where the laser emission is not performed. When the measurement result of each timing is displayed on the display section 70 based on the determination result, the measurement result is displayed with the information that the measurement result indicates the equivalent value of only the number of the neutral particles, or indicates the equivalent value of only the number of the ion particles, or indicates the equivalent value of the sum total of the number of the neutral particles and the number of the ion particles. In addition, a computation result of M⁺/M is displayed in real time.

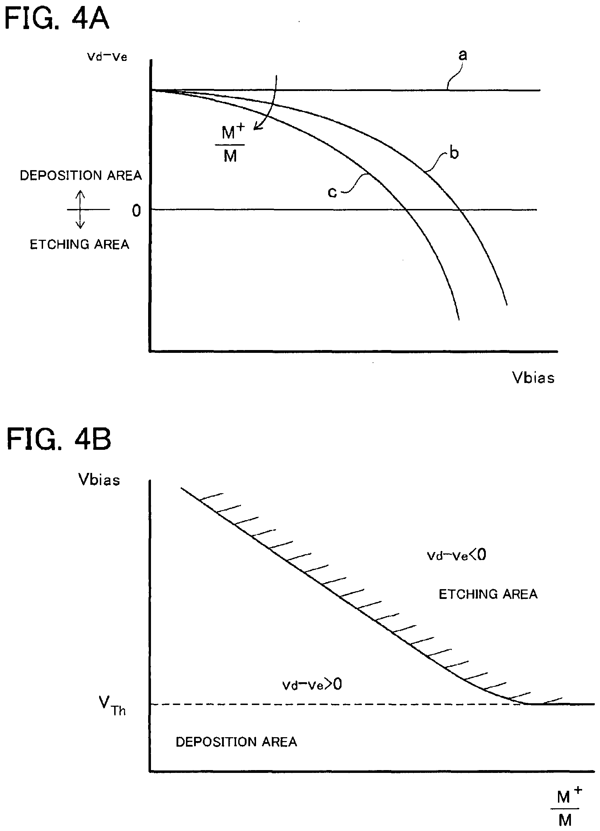

Next, an example of the concept of the method of controlling the film formation or the etching using the observation method of the sputtered particles according to the present disclosure when performing the film formation or the etching of the work by the sputtering using the HIPIMS section 10 of the sputtered particle measuring device 1 according to the present embodiment will be explained with reference to Fig. 4. During the sputtering, the work (not shown) as the object of the sputtering is placed in a predetermined position in the chamber 11. A single element metal target is used as the target 12 also in this explanation, but the present disclosure is not limited to this.

It is thought that the metal ion particles and the metal neutral particles contribute to a metal deposition rate vd, i.e., a film forming rate vd, on the work, and it is thought that the metal ion particles and the sputtering gas ion contribute to an etching rate ve of the work. Next, a method for controlling the film forming and the etching based on the ratio (M⁺/M) (which will be hereinafter referred to as equivalent value ratio) of the equivalent value (M⁺) of the number of the metal ion particles produced by the pulsed electric discharge of the HIPIMS to the equivalent value (M) of the number of the metal neutral particles similarly produced by the pulsed electric discharge will be explained.

Fig. 4A is a conceptual diagram showing a control characteristic diagram obtained by the inventors through the experiments. A vertical axis indicates the value (vd-ve) obtained by subtracting the etching rate ve from the metal deposition rate vd of the work. A horizontal axis indicates the absolute value of the bias voltage Vbias of the work (that is, potential applied to work). The metal deposition rate vd is high and the deposition is promoted in an area where the value (vd-ve) obtained by subtracting the etching rate ve from the metal deposition rate vd is positive. Therefore, this area will be called a deposition area, hereinafter. As contrasted thereto, the etching rate ve is high and the etching is promoted in another area where the value (vd-ve) obtained by subtracting the etching rate ve from the metal deposition rate vd is negative. Therefore, this area will be called an etching area, hereinafter.

A straight line "a" and curve lines "b" and "c" in Fig. 4A each expresses the line, on which the equivalent value ratio (M⁺/M) is a constant value. An arrow (M⁺/M) in Fig. 4A indicates the direction, in which the equivalent value ratio (M⁺/M) increases. With the sputtered particle measuring device 1 according to the present embodiment, the equivalent value (M⁺) of the number of the produced metal ion particles and the equivalent value (M) of the number of the produced metal neutral particles can be measured respectively. Therefore, the equivalent value ratio (M+/M), which is a ratio between them, can be also obtained. Fig. 4B shows the characteristic shown in Fig. 4A in a different manner such that a vertical axis indicates the bias voltage Vbias and a horizontal axis indicates the equivalent value ratio (M⁺/M). V_{Th} indicated on the vertical axis shows a threshold voltage that defines an area where yield of the sputtering is one or lower. This value is dependent on the kinds of the ion and the work.

According to Fig. 4A, it can be grasped clearly whether the actual status is in the deposition area or in the etching area from the equivalent value ratio (M⁺/M) and the bias voltage Vbias. Feedback control of the HIPIMS section 10 may be performed with the controller 30 based on the grasped status. Thus, the HIPIMS section 10 can be controlled to a state for promoting the deposition of the metal on the work or to a state for promoting the etching of the work. As explained above, the present embodiment can measure the respective equivalent values (M⁺, M) and eventually the equivalent value ratio (M⁺/M) within an extremely short time. Therefore, feedback control in real time based on the detection result of the TOF mass spectrometry section 40 can be performed. Thus, it becomes possible to control the film formation on the work and the etching of the work with high precision, whereby highly precise film formation and the etching compliant with the aimed specifications can be performed.

As control on the characteristic chart shown in Fig. 4A, control for changing the equivalent value ratio (M⁺/M) or control for changing the bias voltage Vbias can be performed. As the method for changing the equivalent value ratio (M⁺/M), a method for changing various parameters such as a current, a voltage or a magnetic field applied to the sputtering source 13 or the pressure of the introduced gas can be used. When the control using the current applied to the sputtering source 13 is performed, in order to increase the equivalent value ratio (M⁺/M), the current amount for one time of the pulsed electric discharge may be increased. Similar control may be performed also in the case where the voltage value or the electric energy is controlled instead of the current amount. This control is performed as follows. That is, the controlling section 32 of the controller 30 changes the control value of the power supply 18 based on the detection result received from the TOF specifying section 37 of the TOF mass spectrometry section 40.

In the case of the control of the bias voltage Vbias, if the equivalent value ratio (M⁺/M) is set constant, the etching rate ve increases as the absolute value of the bias voltage (negative potential) is increased (as it goes rightward in Fig. 4A or it goes upward in Fig. 4B). It is because collision of the metal ion particles against the work becomes more intense and contributes more to the etching as the absolute value of the bias voltage Vbias increases. As opposed thereto, the collision of the metal ion particles weakens and the metal ion particles come to contribute to the deposition more as the absolute value of the bias voltage Vbias decreases.

The control of the equivalent value ratio (M⁺/M) and the control of the bias voltage Vbias may be performed in combination.

### (Modification)

In the above embodiment, the equivalent values of the number of the metal neutral particles and the number of the metal ion particles are grasped respectively by the switching on and off of the UV laser irradiation, but the present disclosure is not limited thereto. Alternatively, the equivalent values of both the number of the metal neutral particles and the number of the metal ion particles may be measured simultaneously using only the case where both the pulsed electric discharge and the irradiation of the UV laser are performed.

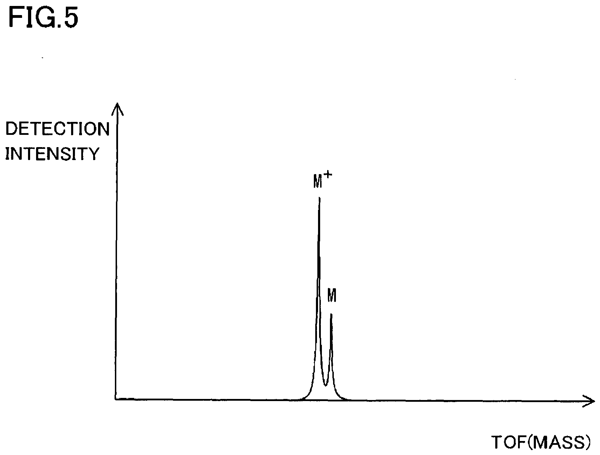

That is, the inventors found that, when the TOF mass spectrometry is conducted by irradiating the metal neutral particles, which are discharged by the HIPIMS, with the UV laser, two peaks appear in the detection intensity of the metal as shown in Fig. 5. The left peak in Fig. 5 is a peak caused by the metal ion particles discharged by the sputtering, and the right peak is a peak caused by the metal ion particles originating from the metal neutral particles discharged by the sputtering. It is considered that the gap in the TOF is caused because the speed of the metal ion particles discharged in the state of the ions is higher than the speed of the neutral particles in the acceleration area. Out of the two detection intensity peaks, the left detection intensity peak in Fig. 5, i.e., the detection intensity with the shorter TOF, may be regarded as the equivalent value (M⁺) of the number of the metal ion particles, and the right detection intensity, i.e., the detection intensity with the longer TOF, may be regarded as the equivalent value (M) of the number of the metal neutral particles. In the case where such method is used, the frequency dividing ratio of the frequency divider 65 of Fig. 1 may be set to 1, or the frequency divider 65 may be omitted. Optionally, two peaks intentionally shifted from each other may be obtained by delaying the irradiation timing of the UV laser from the TOF mass spectrometry start timing (i.e., ion acceleration start timing), for instance, by approximately one microsecond.

In the above-mentioned embodiment, the ratio (M⁺/M) of the equivalent value (M⁺) of the number of the metal ion particles discharged by the HIPIMS to the equivalent value (M) of the number of the metal neutral particles discharged in the same way is used as the equivalent value ratio. Alternatively, a ratio (M⁺/(M+M⁺)) of the equivalent value (M⁺) of the number of the metal ion particles to an equivalent value (M+M⁺) of the sum total of the number of the metal neutral particles and the number of the metal ion particles may be used as the equivalent value ratio.

The configuration of the control system including the controller 30 explained with reference to the above-mentioned embodiment is only an example. Any system configuration may be used as long as the configuration can perform control similar to each of the above-mentioned control.

### (Second embodiment)

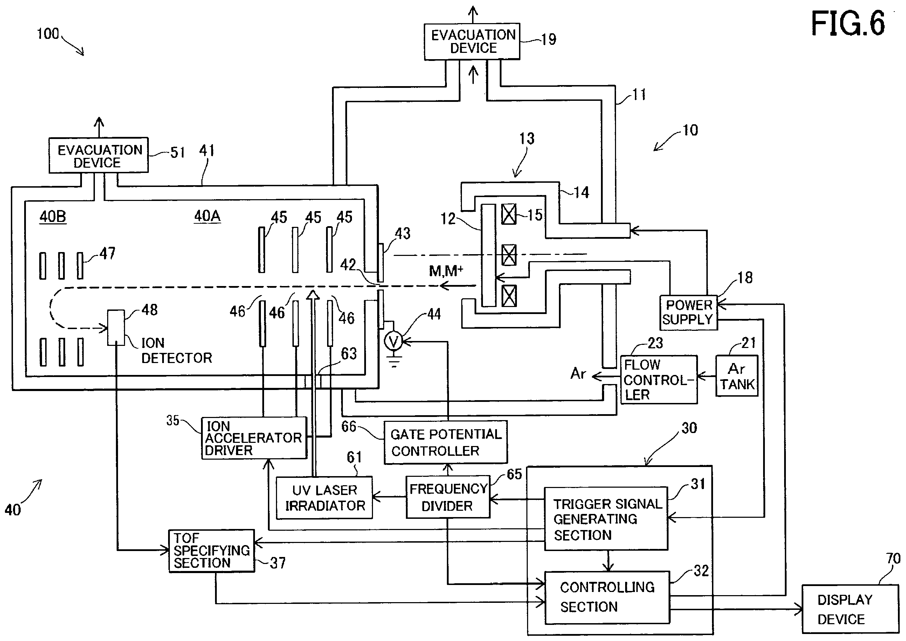

Next, a second embodiment will be described with reference to Figs. 6 and 7. Fig. 6 is a schematic diagram showing a construction of a sputtered particle measuring device 100 according to the second embodiment. The sputtered particle measuring device 100 according to the present embodiment further has a gate potential controller 66 for controlling the potential of the gate 43. The gate potential controller 66 receives the frequency dividing signal from the frequency divider 65 and is capable of controlling the potential of the gate 43 based on the frequency dividing signal.

In the present embodiment, as shown in Fig. 7, the gate potential controller 66 applies the potential Vg to the gate 43 at timing when the gate potential controller 66 receives the frequency dividing signal. The gate potential controller 66 sets the potential of the gate 43 to the ground (Gnd) at the other timings. The potential Vg is applied to the gate 43 only at the timing when the UV laser irradiator 61 emits the UV laser to ionize the neutral particles, thereby prohibiting the ion particles from passing through the gate 43. Thus, the detection intensity by the ion detector 48 corresponding to the timing (t1, t6 shown in Fig. 7) when the frequency dividing signal is emitted serves as the detection intensity of only the ion particles originating from the neutral particles. Therefore, the sputtered particle measuring device 100 according to the present embodiment can measure the equivalent value (M) of only the number of the neutral particles in the sputtered particles directly and with high accuracy.

### (Third embodiment)

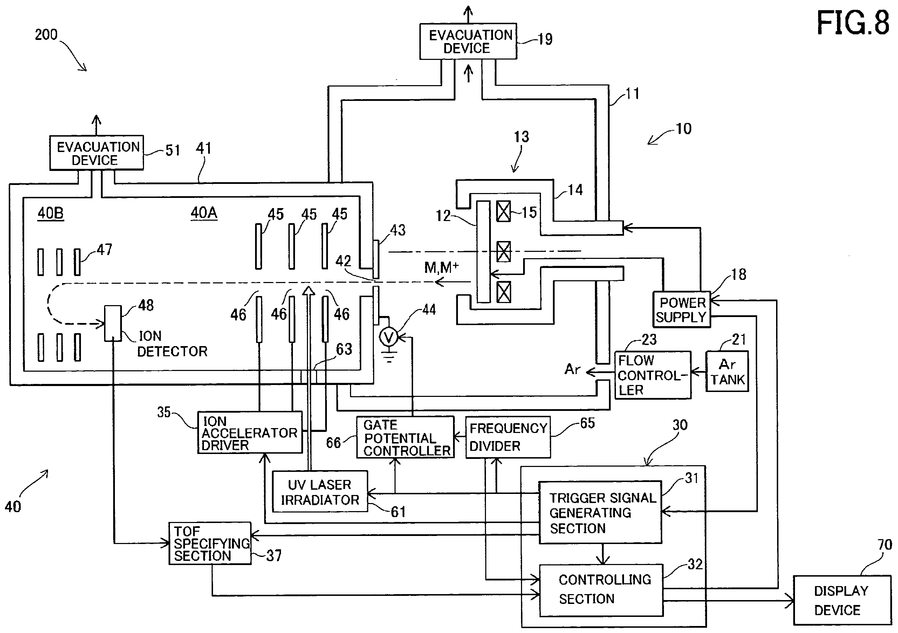

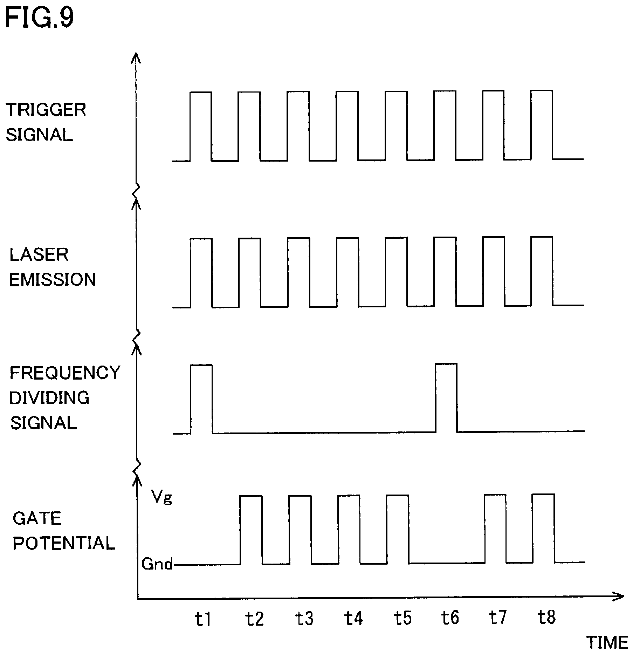

Next, a sputtered particle measuring device 200 according to a third embodiment will be explained with reference to Figs. 8 and 9. In the present embodiment, a UV laser irradiator 61 capable of performing the laser emission in synchronization with the period of the sputtering is used. More specifically, in the present embodiment, as shown in Fig. 9, the trigger signal and the laser emission are synchronized with each other. Fig. 9 shows an example of a sputtered particle measuring method according to the present embodiment. The gate potential controller 66 is used also in the present embodiment. The UV laser irradiator 61 receives the trigger signal from the trigger signal generating section 31 directly. The gate potential controller 66 receives both the trigger signal from the trigger signal generating section 31 and the frequency dividing signal from the frequency divider 65.

As shown in Fig. 9, the gate potential controller 66 according to the present embodiment applies the potential Vg to the gate 43 at the timing when the gate potential controller 66 receives only the trigger signal out of the trigger signal and the frequency dividing signal. The gate potential controller 66 sets the gate potential to the ground (Gnd) at the timing when the gate potential controller 66 receives both of the trigger signal and the frequency dividing signal.

In the present embodiment, the trigger signal and the laser emission are synchronized with each other as shown in Fig. 9, and the neutral sputtered particles are ionized at all the timings when the sputtering is performed. Therefore, the equivalent value (M+M⁺) of the sum total of the number of the neutral particles and the number of the ion particles is detected at the timings t1, t6 when the gate potential is set to the ground (Gnd). The equivalent value (M) of only the number of the neutral particles is detected at the timings t2-t5, t7-t8 when the gate potential is set to the prevention potential Vg,

The ratio between the frequency of the timings t1, t6 when the equivalent value (M+M⁺) of the sum total of the number of the neutral particles and the number of the ion particles is detected and the frequency of the timings t2-t5, t7-t8 when the equivalent value (M) of only the number of the neutral particles is detected can be freely set by the configuration of the frequency dividing ratio. There is a tendency that sensitivity of the detection of the neutral particles produced by each sputtering is lower than sensitivity of the detection of the ion particles produced by each sputtering. Therefore, in the present embodiment, the frequency of the timing when the equivalent value (M) of only the number of the neutral particles is detected is increased to improve the measurement accuracy of the number of the neutral particles.

### (Fourth embodiment)

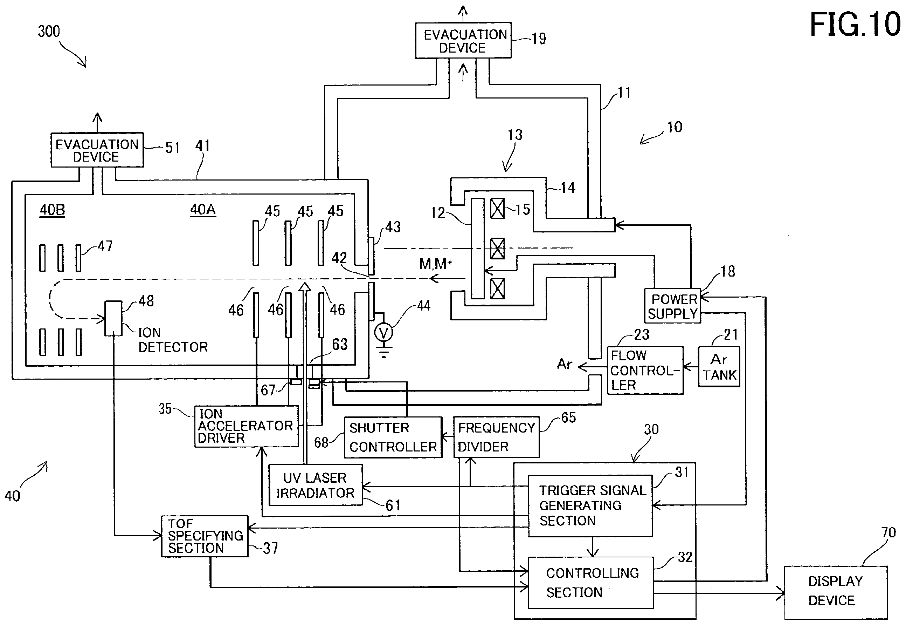

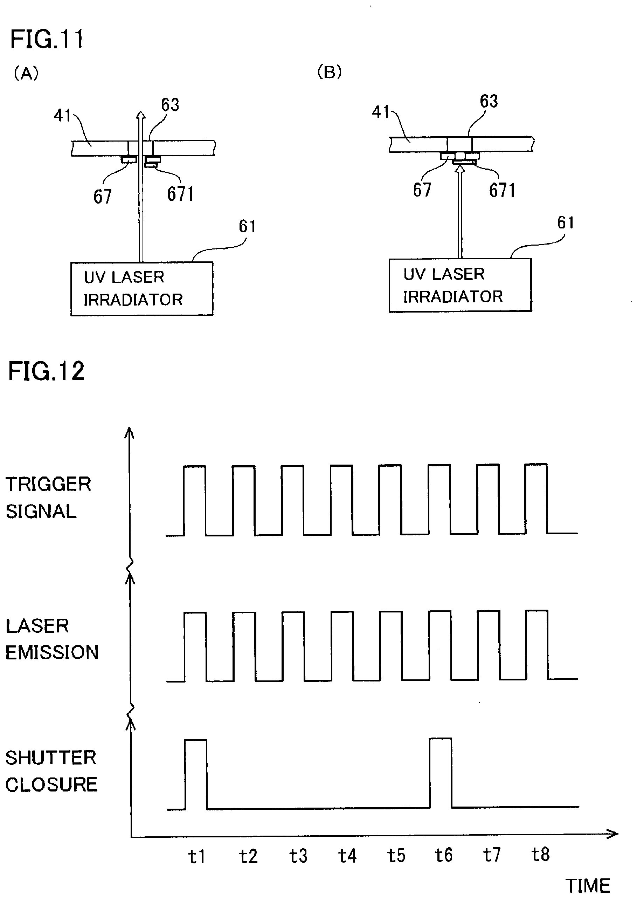

Next, a sputtered particle measuring device 300 according to a fourth embodiment will be explained with reference to Figs. 10 and 11. The sputtered particle measuring device 300 according to the present embodiment shown in Fig. 10 has a shutter 67 and a shutter controller 68 that performs control of opening and closing of the shutter 67. The shutter 67 is provided on the transmission window 63 of the casing 41 of the TOF mass spectrometry section 40. As shown in part (A) of Fig. 11, the shutter 67 permits passage of the UV laser from the UV laser irradiator 61 when a shutter section 671 of the shutter 67 is open. As shown in part (B) of Fig. 11, the shutter 67 prohibits the passage of the UV laser when the shutter section 671 is closed.

Next, a measurement example using the sputtered particle measuring device 300 according to the present embodiment will be explained. As shown in Fig. 12, the UV laser irradiator 61 of the present embodiment receives the trigger signal and can perform the UV laser emission in synchronization with the trigger signal. The frequency dividing signal from the frequency divider 65 of the present embodiment is sent to the shutter controller 68. The shutter controller 68 closes the shutter section 671 at the timing when the shutter controller 68 receives the frequency dividing signal. Fig. 12 schematically shows a relationship among the timings of the trigger signal, the laser emission and the closing operation of the shutter 67.

With the control shown in Fig. 12, at the timings t1, t6 when the shutter 67 is closed, the emitted UV laser is blocked by the shutter 67, so the neutral particles are not ionized. Therefore, the equivalent value (M⁺) of only the number of the ion particles is detected at such the timings t1, t6. The sum total (M+M⁺) of the equivalent value (M) of the number of the neutral particles and the equivalent value (M⁺) of the number of the ion particles is obtained at the other timings t2-t5, t7-t8. The frequency dividing ratio is arbitrary. Instead of the control for closing the shutter 67 according to the frequency dividing signal, control for opening the shutter 67 may be used. Alternatively, the present embodiment may be used in combination with the control of the gate potential defined in the explanation of the third embodiment. A mirror that reflects the laser light may be used in place of the shutter 67. In that case, effects similar to those explained above can be exerted by controlling the UV laser irradiation to the neutral particles using rotation operation of the mirror instead of the opening-closing operation of the shutter 67.

### (Fifth embodiment)

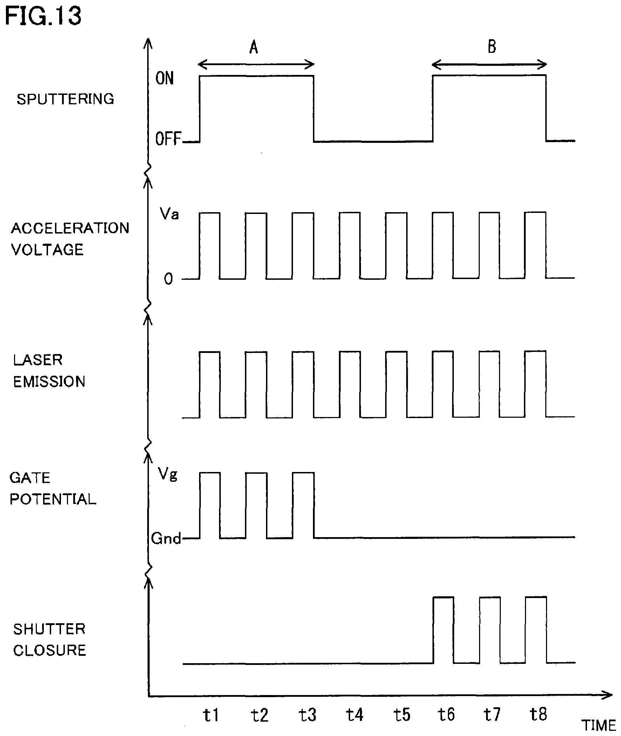

Next, a sputtered particle measuring method according to a fifth embodiment will be explained with reference to Fig. 13. The UV laser irradiator 61 according to the present embodiment can emit the UV laser in a period shorter than the sputtering period. For instance, in an example shown in Fig. 13, three times of the UV laser irradiation is performed in a period in which one time of the sputtering is performed (i.e., period when "SPUTTERING" is "ON" in Fig. 13, which is for instance approximately 100 microseconds). For instance, a period of each laser irradiation is several picoseconds to several nanoseconds. Here, "one time of sputtering" means duration from a start to an end of the sputtering caused by one time of the pulsed electric discharge. Fig. 13 schematically shows a relationship among the timings of the sputtering, the application of the acceleration voltage, the laser emission, the control of the gate potential and the control of the shutter 67. A construction and a method for the control of the gate potential and the shutter 67 are the same as those of the above-mentioned embodiment.

Fig. 13 shows two successive sputtering periods A and B. For the measurement of the sputtered particle at each laser emission timing, the acceleration voltage Va is applied to the acceleration electrode 45 to accelerate the particles at the each laser emission timing. The gate 43 is controlled to the prevention potential Vg at each of the laser emission timings t1, t2, t3 in the period A. The shutter 67 is closed at each of the laser emission timings t6, t7, t8 in the period B. Thus, the equivalent value (M) of the number of only the neutral particles is measured at each of the timings t1, t2, t3 in the period A. The equivalent value (M⁺) of the number of only the ion particles is measured at each of the timings t6, t7, t8 in the period B. In this way, by measuring the equivalent value (M) of the number of only the neutral particles or the equivalent value (M⁺) of the number of only the ion particles in each one of the successive periods A and B respectively, measurement accuracy can be improved. It is not necessary that the periods A and B are periods occurring alternately. The periods A and B may be set arbitrarily. For instance, a ratio between frequencies of occurrence of the periods A and B may be set at an integral ratio. The number of the UV laser irradiation in each of the periods may be set arbitrarily in accordance with the configuration of the device.

In the above explanation, it is assumed that the positive ions are the object of the detection by the ion detector 48. The present disclosure is not limited thereto. Alternatively, negative ions may be used as the object of the detection by the ion detector 48. In the measurement of the kind and the equivalent value (M⁻) of the negative ions in that case, the potentials applied to the gate 43 and the respective electrodes included in the TOF-mass analyzer 40 may be adjusted as appropriate.

That is, when the negative ions are used as the object of the detection, the gate can be switched between the state where the gate 43 is earthed to the ground (Gnd) and a state where the gate 43 is set to a certain potential by the potential changing circuit 44. In the state where the gate 43 is set to the certain potential, the gate 43 as the ion introduction hole of the TOF mass spectrometry section 40 is set to a potential equal to or higher than the earth, so the introduction of the negative ions to the inside of the casing 41 is facilitated. By maintaining the gate 43 to a plasma potential, i.e., a predetermined potential (e.g., potential lower than approximately -20 V) equal to or lower than a potential exceeding an energy, which the ion can have, the gate 43 can function as a prevention electrode. Thus, the entrance of the ions to the inside of the casing 41 through the aperture 42 can be prevented. Also, the polarity of the voltage applied to the ion acceleration electrodes 45 for accelerating the negative ions in the TOF mass spectrometry is inverted to the negative voltage.

In the above, as the system for discharging the particles from the target (which will be referred to as "system of evaporation source," hereafter), the system for discharging the particles from the target using the pulsed electric discharge, or more specifically the system using the HIPIMS, is explained as an example. However, the present disclosure is not limited thereto. Alternatively, any other method such as the DC magnetron sputtering method, the high-frequency magnetron sputtering method, the arc discharge method or the laser ablation method can be used. When necessary, the system may have a device for generating a trigger signal independently (i.e., independently from operation of evaporation source), the trigger signal serving as the reference for the measurement of the particles. Thus, any kind of system can be employed as the system of the evaporation source to realize the measurement explained in the description of the above embodiments, the modification and the working example.

More specifically, for instance, a device for outputting the trigger signal shown in Fig. 2 independently (i.e., independently from operation of evaporation source) may be provided, and the frequency dividing signal may be generated based on the trigger signal. Thus, like the first embodiment, the equivalent value of the neutral particles and the equivalent value of the ion particles can be obtained. In this case, the kind and the intensity of the particles can be measured in a short time not only with the configuration that discharges the particles in the pulse shape from the target but also with the configuration that discharges the particles continuously as the configuration of the evaporation source. Such alternation can be also applied to the other embodiments than the first embodiments and the modification similarly. That is, a device for outputting the trigger signal independently from the drive of the evaporation source may be provided and the frequency dividing signal may be generated from the trigger signal, and the control of the gate 43, the UV laser irradiator 61 and the shutter 67 may be performed and the analysis with the TOF mass spectrometry section 40 may be performed based on these signals.

The present disclosure is not limited to the embodiments of the invention and the explanation of the embodiments. Various modifications thereof, which do not depart from the scope of the claims and which can be easily thought of by a person skilled in the art, are included in the present invention. For instance, any feasible combinations of the embodiments, the modification and the working example mentioned above are included in the present disclosure.

The invention is defined by the claims.

### [Explanation of numeral references]

- 1, 100, 200, 300: Sputtered particle measuring device
- 10: HIPIMS section
- 11: Chamber
- 12: Target
- 13: Sputtering source
- 14: Anode electrode
- 15: Magnet unit
- 18: Power supply
- 19: Evacuation device
- 30: Controller
- 31: Trigger signal generating section
- 32: Controlling section
- 35: Ion accelerator driver
- 37: TOF specifying section
- 40: TOF mass spectrometry section
- 41: Casing
- 43: Gate
- 44: Potential changing circuit
- 45: Ion accelerator
- 47: Reflector
- 48: Ion detector
- 61: UV laser irradiator
- 65: Frequency divider
- 66: Gate potential controller
- 67: Shutter
- 68: Sutter controller
- 70: Display device

## Claims

1. A sputtered particle measuring device (1, 100, 200, 300) comprising:
a sputtering source (13) comprising a target (12);
a power supply (18) arranged to supply pulsed electric power to the sputtering source (13) so as to generate a pulsed electric discharge; a measuring section (40) arranged to measure a ratio between an equivalent value of the number of ion particles discharged from the target (12) by sputtering caused by a pulsed electric discharge and an equivalent value of the number of neutral particles discharged from the target (12) by the sputtering caused by the pulsed electric discharge;
an ionizing section (61) arranged to ionize the neutral particles discharged from the target (12) by the sputtering;
a frequency divider (65) arranged to generate a frequency dividing signal based on a pulse signal synchronized with an occurrence of the pulsed electric discharge, the frequency dividing signal having a period that is an integral multiple of a period of the pulse signal;
a driver arranged to drive the ionizing section (61) with the frequency dividing signal; and
a controller (30) arranged to cause the frequency dividing signal to be generated at a first timing;
wherein the pulsed electric discharge is constituted by a plurality of successive pulsed electric discharges, and wherein the measuring section (40) is arranged to measure the ratio based on the equivalent value or the equivalent values of either or both of the ion particles and the neutral particles discharged from the target by the sputtering caused by the pulsed electric discharge occurring at the first timing and based on the equivalent value or the equivalent values of either or both of the ion particles and the neutral particles discharged from the target by the sputtering caused by the pulsed electric discharge occurring at a timing different from the first timing.

2. A sputtered particle measuring device (1, 100, 200, 300) comprising:
a sputtering source (13) comprising a target (12); a power supply (18)arranged to supply pulsed electric power to the sputtering source (13) so as to generate a pulsed electric discharge; a measuring section (40) arranged to measure a ratio between an equivalent value of the number of ion particles discharged from the target (12) by sputtering caused by a pulsed electric discharge and an equivalent value of the number of neutral particles discharged from the target (12) by the sputtering caused by the pulsed electric discharge;
an ionizing section (61) arranged to ionize the neutral particles discharged from the target (12) by the sputtering;
a frequency divider (65) arranged to generate a frequency dividing signal based on a pulse signal synchronized with an occurrence of the pulsed electric discharge, the frequency dividing signal having a period that is an integral multiple of a period of the pulse signal;
a section (67) arranged to allow or prohibit the ionization of the neutral particles by the ionizing section (61) based on the frequency dividing signal; and
a controller (30) arranged to cause the frequency dividing signal to be generated at a first timing;
wherein the pulsed electric discharge is constituted by a plurality of successive pulsed electric discharges, and wherein the measuring section (40) is arranged to measure the ratio based on the equivalent value or the equivalent values of either or both of the ion particles and the neutral particles discharged from the target by the sputtering caused by the pulsed electric discharge occurring at the first timing and based on the equivalent value or the equivalent values of either or both of the ion particles and the neutral particles discharged from the target by the sputtering caused by the pulsed electric discharge occurring at a timing different from the first timing.

3. The sputtered particle measuring device (1, 100, 200, 300) as in claim 1 or 2, wherein the frequency dividing signal has a period that is an integral multiple of the period of the pulse signal and that is two to ten times the period of the pulse signal.

4. The sputtered particle measuring device (1, 100, 200, 300) as in any one of claims 1-3, further comprising an ion particle removing section (43) arranged to remove the ion particles discharged from the target (12) by the sputtering.

5. The sputtered particle measuring device (1, 100, 200, 300) as in claim 4, further comprising a section arranged to synchronize the drive of the ionizing section (61) and the drive of the ion particle removing section (43).

6. The sputtered particle measuring device (1, 100, 200, 300) as in any one of claims 1-3 and 5, wherein the measuring section (40) is arranged to measure the equivalent values of the number of the ion particles and of the neutral particles by time-of-flight mass spectrometry.

7. A sputtering device using the high power impulse magnetron sputtering method, HIPIMS, the sputtering device comprising: a controller arranged to control either or both of a current amount, a voltage or an electric energy for the discharge during each pulsed electric discharge of the HIPIMS and a bias voltage applicable to a work as a processing object of the sputtering device based on the ratio of the equivalent values measured by the sputtered particle measuring device (1, 100, 200, 300) of any one of claims 1-6.

8. A sputtered particle measuring method, comprising:
a measuring step of measuring a ratio between an equivalent value of the number of ion particles discharged from a target (12) by sputtering caused by a pulsed electric discharge and an equivalent value of the number of neutral particles discharged from the target (12) by the sputtering caused by the pulsed electric discharge;
an ionizing step of ionizing the neutral particles discharged from the target (12) by the sputtering;
a frequency dividing step of generating a frequency dividing signal based on a pulse signal synchronized with the occurrence of the pulsed electric discharge, the frequency dividing signal having a period that is an integral multiple of a period of the pulse signal;
an executing step of executing the ionizing step with the frequency dividing signal; and
a step of generating the frequency dividing signal at a first timing;
wherein the pulsed electric discharge is constituted by a plurality of successive pulsed electric discharges, and wherein the measuring step measures the ratio based on the equivalent value or the equivalent values of either or both of the ion particles and the neutral particles discharged from the target by the sputtering caused by the pulsed electric discharge occurring at the first timing and based on the equivalent value or the equivalent values of either or both of the ion particles and the neutral particles discharged from the target by the sputtering caused by the pulsed electric discharge occurring at a timing different from the first timing.

9. A sputtered particle measuring method, comprising:
a measuring step of measuring a ratio between an equivalent value of the number of ion particles discharged from a target (12) by sputtering caused by a pulsed electric discharge and an equivalent value of the number of neutral particles discharged from the target (12) by the sputtering caused by the pulsed electric discharge;
an ionizing step of ionizing the neutral particles discharged from the target (12) by the sputtering;
a frequency dividing step of generating a frequency dividing signal based on a pulse signal synchronized with the occurrence of the pulsed electric discharge, the frequency dividing signal having a period that is an integral multiple of a period of the pulse signal;
a step of allowing or prohibiting the ionization of the neutral particles in the ionizing step based on the frequency dividing signal; and
a step of generating the frequency dividing signal at a first timing;
wherein the pulsed electric discharge is constituted by a plurality of successive pulsed electric discharges, and wherein the measuring step measures the ratio based on the equivalent value or the equivalent values of either or both of the ion particles and the neutral particles discharged from the target by the sputtering caused by the pulsed electric discharge occurring at the first timing and based on the equivalent value or the equivalent values of either or both of the ion particles and the neutral particles discharged from the target by the sputtering caused by the pulsed electric discharge occurring at a timing different from the first timing.

10. The sputtered particle measuring method as in claim 8 or 9, wherein the frequency dividing signal has a period that is an integral multiple of the period of the pulse signal and that is two to ten times the period of the pulse signal.

11. The sputtered particle measuring method as in any one of claims 8 to 10, further comprising an ion particle removing step of removing the first ion particles discharged from the target (12) by the sputtering.

12. The sputtered particle measuring method as in claim 11, further comprising a step of synchronizing the execution of the ionizing step and the execution of the ion particle removing step.

13. The sputtered particle measuring method as in any one of claims 8 to 12, wherein the measuring step measures the equivalent values of the number of the ion particles and of the neutral particles by time-of-flight mass spectrometry.

14. A sputtering method using the high power impulse magnetron sputtering method, HIPIMS, comprising: a controlling step of controlling either or both of a current amount, a voltage or an electric energy for the discharge during each pulsed electric discharge of the HIPIMS and a bias voltage applied to a work as a processing object of the sputtering method based on the ratio of the equivalent values measured by the sputtered particle measuring method as in any one of claims 8 to 13.

## Patentansprüche

1. Ionendampfpartikel-Messgerät (1, 100, 200, 300), das Folgendes enthält:
eine Ionenverdampfungsquelle (13), die ein Objektiv (12) enthält;
ein Netzteil (18), das so angeordnet ist, dass es die Ionenverdampfungsquelle (13) mit elektrischer Leistung versorgt, um eine elektrische Impulsentladung zu erzeugen;
einen Messabschnitt (40), der so angeordnet ist, dass er ein Verhältnis zwischen einem äquivalenten Wert der Anzahl der entladenen Ionenpartikel vom Objektiv (12) durch Ionenverdampfung misst, die durch eine elektrische Impulsentladung und einen äquivalenten Wert der Anzahl der neutralen entladenen Partikel vom Objektiv (12) durch die Ionenverdampfung erzeugt wird, die durch die elektrische Impulsentladung erzeugt wurde;
einen Ionisationsabschnitt (61), der so angeordnet ist, dass er die entladenen neutralen Partikel vom Objektiv (12) durch Ionenverdampfung ionisiert;
einen Frequenzdivisor (65), der so angeordnet ist, dass er ein Frequenzdivisionssignal erzeugt, das auf einem Impulssignal basiert, welches mit dem Auftreten der elektrischen Impulsladung synchronisiert ist, das Frequenzdivisionssignal hat einen Zeitraum, der ein ganzes Mehrfaches eines Zeitraums des Impulssignals ist;
ein Steuerelement, das so angeordnet ist, dass es den Ionisationsabschnitt (61) mit dem Frequenzdivisionssignal steuert; und
ein Kontrollgerät (30), das so angeordnet ist, dass es veranlasst, dass das Frequenzdivisionssignal bei einer ersten Taktgebung erzeugt wird;
wobei die elektrische Impulsentladung aus mehreren aufeinanderfolgenden elektrischen Impulsentladungen besteht und wobei der Messabschnitt (40) so angeordnet ist, dass er das Verhältnis misst, welches auf dem äquivalenten Wert oder den äquivalenten Werten einer oder beider Ionenpartikel und den neutralen vom Objektiv durch Ionenverdampfung entladenen neutralen Partikeln basiert, die durch die elektrische Impulsentladung verursacht wird, welche bei der ersten Taktgebung erfolgt und auf einem äquivalenten oder den äquivalenten Werten einer oder beider Ionenpartikel und den neutralen vom Objektiv durch Ionenverdampfung entladenen neutralen Partikeln basiert, die durch die elektrische Impulsentladung verursacht wird, die mit einer anderen als der ersten Taktgebung erfolgt.

2. Ionendampfpartikel-Messgerät (1, 100, 200, 300), das Folgendes enthält:
eine Ionenverdampfungsquelle (13), die ein Objektiv (12) enthält;
ein Netzteil (18), das so angeordnet ist, dass es die Ionenverdampfungsquelle (13) mit elektrischer Leistung versorgt, um eine elektrische Impulsentladung zu erzeugen;
einen Messabschnitt (40), der so angeordnet ist, dass er ein Verhältnis zwischen einem äquivalenten Wert der Anzahl der entladenen Ionenpartikel vom Objektiv (12) durch Ionenverdampfung misst, die durch eine elektrische Impulsentladung und einen äquivalenten Wert der Anzahl der neutralen entladenen Partikel vom Objektiv (12) durch die Ionenverdampfung erzeugt wird, die durch die elektrische Impulsentladung erzeugt wurde;
einen Ionisationsabschnitt (61), der so angeordnet ist, dass er die entladenen neutralen Partikel vom Objektiv (12) durch Ionenverdampfung ionisiert;
einen Frequenzdivisor (65), der so angeordnet ist, dass er ein Frequenzdivisionssignal erzeugt, das auf einem Impulssignal basiert, welches mit dem Auftreten der elektrischen Impulsladung synchronisiert ist, das Frequenzdivisionssignal hat einen Zeitraum, der ein ganzes Mehrfaches eines Zeitraums des Impulssignals ist;
einen Abschnitt (67), der so angeordnet ist, dass er die Ionisation der neutralen Partikel durch den Ionisationsabschnitt (61) ermöglicht oder verbietet, der auf dem Frequenzdivisionssignal basiert; und
ein Kontrollgerät (30), das so angeordnet ist, dass es veranlasst, dass das Frequenzdivisionssignal bei einer ersten Taktgebung erzeugt wird;
wobei die elektrische Impulsentladung aus mehreren aufeinanderfolgenden elektrischen Impulsentladungen besteht und wobei der Messabschnitt (40) so angeordnet ist, dass er das Verhältnis misst, welches auf dem äquivalenten Wert oder den äquivalenten Werten einer oder beider Ionenpartikel und den neutralen vom Objektiv durch Ionenverdampfung entladenen neutralen Partikeln basiert, die durch die elektrische Impulsentladung verursacht wird, welche bei der ersten Taktgebung erfolgt und auf einem äquivalenten oder den äquivalenten Werten einer oder beider Ionenpartikel und den neutralen vom Objektiv durch Ionenverdampfung entladenen neutralen Partikeln basiert, die durch die elektrische Impulsentladung verursacht wird, die mit einer anderen als der ersten Taktgebung erfolgt.

3. Ionendampfpartikel-Messgerät (1, 100, 200, 300) gemäß Patentanspruch 1 oder 2, wo das Frequenzdivisionssignal einen Zeitraum hat, der ein ganzes Mehrfaches des Zeitraums des Impulssignals ist und das von zwei bis zehn Mal dem Zeitraum des Impulssignals entspricht.

4. Ionendampfpartikel-Messgerät (1, 100, 200, 300) gemäß einem beliebigen der Patentansprüche 1 - 3, das außerdem einen Abschnitt zur Entfernung der Ionenpartikel (43) enthält, welches so angeordnet ist, dass es die vom Objektiv (12) durch die Ionenverdampfung entladenen Ionenpartikel entfernt.

5. Ionendampfpartikel-Messgerät (1, 100, 200, 300) gemäß Patentanspruch 4, das außerdem einen Abschnitt enthält, der so angeordnet ist, dass die Steuerung des Ionisationsabschnitts (61) und die Steuerung des Abschnitts zur Entfernung der Ionenpartikel (43) synchronisiert werden.

6. Ionendampfpartikel-Messgerät (1, 100, 200, 300) gemäß einem beliebigen der Patentansprüche 1 - 3 und 5, wobei der Messabschnitt (40) so angeordnet ist, dass er die äquivalenten Werte der Anzahl der Ionenpartikel und der neutralen Partikel durch Massenspektrometrie der Flugzeit misst.

7. Ionenverdampfungsgerät, das eine Ionenverdampfungsmethode mit Hochleistungsimpulsen, HIPIMS, verwendet, das Ionenverdampfungsgerät enthält:
ein Kontrollgerät, das so angeordnet ist, dass es eine oder beide Strommengen, eine Spannung oder eine elektrische Energie für die Entladung während jeder elektrischen Impulsentladung des HIPIMS und eine Polarisationsspannung steuert, die auf eine Arbeit als Bearbeitungsgegenstand des Ionenverdampfungsgeräts anwendbar ist, welches auf dem Verhältnis der äquivalenten Werte basiert, die durch das Ionendampfpartikel-Messgerät (1, 100, 200, 300) gemäß einem beliebigen der Patentansprüche 1 - 6 gemessen wird.

8. Ionendampfpartikel-Messmethode, die Folgendes enthält:
eine Messphase, um ein Verhältnis zwischen einem äquivalenten Wert der Anzahl der entladenen Ionenpartikel von einem Objektiv (12) durch Ionenverdampfung zu messen, die durch eine elektrische Impulsentladung und einen äquivalenten Wert der Anzahl der neutralen entladenen Partikel vom Objektiv (12) durch die Ionenverdampfung erzeugt wird, die durch die elektrische Impulsentladung erzeugt wird;
eine Ionisationsphase, um die entladenen neutralen Partikel vom Objektiv (12) durch Ionenverdampfung zu ionisieren;
eine Frequenzdivisionsphase, um ein Frequenzdivisionssignal zu erzeugen, das auf einem Impulssignal basiert, welches mit dem Auftreten der elektrischen Impulsladung synchronisiert ist, das Frequenzdivisionssignal hat einen Zeitraum, der ein ganzes Mehrfaches eines Zeitraums des Impulssignals ist;
eine Ausführungsphase, um die Ionisationsphase mit dem Frequenzdivisionssignal zu steuern; und
eine Erzeugungsphase des Frequenzdivisionssignals bei einer ersten Taktgebung;
wobei die elektrische Impulsentladung aus mehreren aufeinanderfolgenden elektrischen Impulsentladungen besteht und wobei die Messphase das Verhältnis misst, welches auf dem äquivalenten Wert oder den äquivalenten Werten einer oder beider Ionenpartikel und den neutralen vom Objektiv durch Ionenverdampfung entladenen neutralen Partikeln basiert, die durch die elektrische Impulsentladung verursacht wird, welche vor der Taktgebung erfolgt und auf einem äquivalenten oder den äquivalenten Werten einer oder beider Ionenpartikel und den neutralen vom Objektiv durch Ionenverdampfung entladenen neutralen Partikeln basiert, die durch die elektrische Impulsentladung verursacht wird, die mit einer anderen als der ersten Taktgebung erfolgt.

9. Ionendampfpartikel-Messmethode, die Folgendes enthält:
eine Messphase, um ein Verhältnis zwischen einem äquivalenten Wert der Anzahl der entladenen Ionenpartikel von einem Objektiv (12) durch Ionenverdampfung zu messen, die durch eine elektrische Impulsentladung und einen äquivalenten Wert der Anzahl der neutralen entladenen Partikel vom Objektiv (12) durch die Ionenverdampfung erzeugt wird, die durch die elektrische Impulsentladung erzeugt wird;
eine Ionisationsphase, um die entladenen neutralen Partikel vom Objektiv (12) durch Ionenverdampfung zu ionisieren;
eine Frequenzdivisionsphase, um ein Frequenzdivisionssignal zu erzeugen, das auf einem Impulssignal basiert, welches mit dem Auftreten der elektrischen Impulsladung synchronisiert ist, das Frequenzdivisionssignal hat einen Zeitraum, der ein ganzes Mehrfaches eines Zeitraums des Impulssignals ist;
eine Phase, um die Ionisation der neutralen Partikel durch den Ionisationsabschnitt zu ermöglichen oder zu verbieten, die auf dem Frequenzdivisionssignal basiert; und
eine Erzeugungsphase des Frequenzdivisionssignals bei einer ersten Taktgebung;
wobei die elektrische Impulsentladung aus mehreren aufeinanderfolgenden elektrischen Impulsentladungen besteht und wobei die Messphase das Verhältnis misst, welches auf dem äquivalenten Wert oder den äquivalenten Werten einer oder beider Ionenpartikel und den neutralen vom Objektiv durch Ionenverdampfung entladenen neutralen Partikeln basiert, die durch die elektrische Impulsentladung verursacht wird, welche bei der ersten Taktgebung erfolgt und auf einem äquivalenten oder den äquivalenten Werten einer oder beider Ionenpartikel und den neutralen vom Objektiv durch Ionenverdampfung entladenen neutralen Partikeln basiert, die durch die elektrische Impulsentladung verursacht wird, die mit einer anderen als der ersten Taktgebung erfolgt.

10. Ionendampfpartikel-Messmethode gemäß Patentanspruch 8 oder 9, wo das Frequenzdivisionssignal einen Zeitraum hat, der ein ganzes Mehrfaches des Zeitraums des Impulssignals ist und der von zwei bis zehn Mal dem Zeitraum des Impulssignals entspricht.

11. Ionendampfpartikel-Messmethode gemäß einem beliebigen der Patentansprüche von 8 bis 10, die außerdem eine Phase zur Entfernung der Ionenpartikel enthält, um die ersten durch die Ionenverdampfung entladenen Ionenpartikel zu entfernen.

12. Ionendampfpartikel-Messmethode gemäß Patentanspruch 11, die außerdem eine Synchronisationsphase zur Ausführung der Ionisationsphase und zur Ausführung der Phase zur Entfernung der Ionenpartikel enthält.

13. Ionendampfpartikel-Messphase gemäß einem beliebigen der Patentansprüche von 8 bis 12, wobei die Messphase die äquivalenten Werte der Anzahl der Ionenpartikel und der neutralen Partikel durch Massenspektrometrie der Flugzeit misst.

14. Ionenverdampfungsmethode, die eine Ionenverdampfungsmethode mit Hochleistungsimpulsen, HIPIMS, verwendet und Folgendes enthält:
eine Kontrollphase, um eine oder beide Strommengen, eine Spannung oder eine elektrische Energie für die Entladung während jeder elektrischen Impulsentladung des HIPIMS und eine Polarisationsspannung zu steuern, die auf eine Arbeit als Bearbeitungsgegenstand der Ionenverdampfungsmethode anwendbar ist, welche auf dem Verhältnis der äquivalenten Werte basiert, die durch die Ionendampfpartikel-Messmethode gemäß einem beliebigen der Patentansprüche von 8 - 13 gemessen wird.

## Revendications

1. Dispositif de mesure de particules pulvérisées de manière ionique (1, 100, 200, 300) comprenant :
une source de pulvérisation ionique (13) comprenant un objectif (12) ;
un alimentateur (18) positionné de sorte à alimenter la puissance électrique impulsée à la source de pulvérisation ionique (13) afin de créer une décharge électrique impulsée ;
une section de mesure (40) positionnée de sorte à mesurer un rapport entre une valeur équivalente du nombre de particules d'ions déchargées par l'objectif (12) à travers la pulvérisation ionique causée par une décharge électrique impulsée et une valeur équivalente du nombre de particules neutres déchargées par l'objectif (12) à travers la pulvérisation ionique causée par la décharge électrique impulsée;
une section d'ionisation (61) positionnée de sorte à ioniser les particules neutres déchargées par l'objectif (12) à travers la pulvérisation ionique ;
un séparateur de fréquence (65) positionné de sorte à générer un signal de séparation de fréquence basé sur un signal à impulsions synchronisé avec l'apparition de la décharge électrique impulsée, le signal de séparation de fréquence possède une période qui est un multiple entier d'une période du signal à impulsions ;
un élément de pilotage positionné de sorte à piloter la section d'ionisation (61) avec le signal de séparation de fréquence ; et
un contrôleur (30) positionné de sorte à ce que le signal de séparation de fréquence soit engendré à une première temporisation ;
où la décharge électrique impulsée est composée d'une pluralité de décharges électriques impulsées successives, et où la section de mesure (40) est positionnée de sorte à mesurer le rapport basé sur la valeur équivalente ou les valeurs équivalentes d'une ou des deux particules d'ions et les particules neutres déchargées par l'objectif à travers la pulvérisation ionique causée par la décharge électrique impulsée qui se produit à la première temporisation et en se basant sur la valeur équivalente ou les valeurs équivalentes d'une ou des deux particules d'ions et les particules neutres déchargées par l'objectif à travers la pulvérisation ionique causée par la décharge électrique impulsée qui se produit à une temporisation différente de la première temporisation.

2. Dispositif de mesure de particules pulvérisées de manière ionique (1, 100, 200, 300) comprenant :
une source de pulvérisation ionique (13) comprenant un objectif (12) ;
un alimentateur (18) positionné de sorte à alimenter une puissance électrique impulsée à la source de pulvérisation ionique (13) de sorte à générer une décharge électrique impulsée ;
une section de mesure (40) positionnée de sorte à mesurer un rapport entre une valeur équivalente du nombre de particules d'ions déchargées par l'objectif (12) à travers la pulvérisation ionique causée par une décharge électrique impulsée et une valeur équivalente du nombre de particules neutres déchargées par l'objectif (12) à travers la pulvérisation ionique causée par la décharge électrique impulsée ;
une section d'ionisation (61) positionnée de sorte à ioniser les particules neutres déchargées par l'objectif (12) à travers la pulvérisation ionique ;
un séparateur de fréquence (65) positionné de sorte à générer un signal de séparation de fréquence basé sur un signal à impulsions synchronisé avec l'apparition de la décharge électrique impulsée, le signal de séparation de fréquence possède une période qui est un multiple entier d'une période du signal à impulsions ;
une section (67) positionnée de sorte à permettre ou empêcher l'ionisation des particules neutres par la section d'ionisation (61) en se basant sur le signal de séparation de fréquence ; et
un contrôleur (30) positionné de sorte à ce que le signal de séparation de fréquence soit engendré à une première temporisation ;
où la décharge électrique impulsée est constituée d'une pluralité de décharges électriques impulsées successives, et où la section de mesure (40) est positionnée de sorte à mesurer le rapport basé sur la valeur équivalente ou les valeurs équivalentes d'une ou des deux particules d'ions et les particules neutres déchargées par l'objectif à travers la pulvérisation ionique causée par la décharge électrique impulsée qui se produit à la première temporisation et en se basant sur la valeur équivalente ou les valeurs équivalentes d'une ou des deux particules d'ions et les particules neutres déchargées par l'objectif à travers la pulvérisation ionique causée par la décharge électrique impulsée qui se produit à une temporisation différente de la première temporisation.

3. Dispositif de mesure de particules pulvérisées de manière ionique (1, 100, 200, 300), selon la revendication 1 ou 2, où le signal de séparation de fréquence possède une période qui est un multiple entier de la période du signal à impulsions et qui dépasse de deux à dix fois la valeur de la période du signal à impulsions.

4. Dispositif de mesure de particules pulvérisées de manière ionique (1, 100, 200, 300), selon l'une des revendications 1-3, comprenant en outre une section d'élimination de particules d'ions (43) positionnée de sorte à éliminer les particules d'ions déchargées par l'objectif (12) à travers la pulvérisation ionique.

5. Dispositif de mesure de particules pulvérisées de manière ionique (1, 100, 200, 300), selon la revendication 4, comprenant en outre une section positionnée de sorte à synchroniser la commande de la section d'ionisation (61) et la commande de la section d'élimination de particules d'ions (43).

6. Dispositif de mesure de particules pulvérisées de manière ionique (1, 100, 200, 300), selon l'une des revendications 1-3 et 5, où la section de mesure (40) est positionnée de sorte à mesurer les valeurs équivalentes du nombre de particules d'ions et des particules neutres à travers une spectrométrie de masse du temps de vol.

7. Dispositif de pulvérisation ionique qui utilise une méthode de pulvérisation ionique à impulsions à puissance élevée, HIPIMS, le dispositif de pulvérisation ionique comprend :
un contrôleur positionné de sorte à contrôler, une ou les deux, une quantité de courant, une tension ou une énergie électrique pour la décharge pendant chaque décharge électrique impulsée du HIPIMS et une tension de polarisation applicable à un travail comme objet de traitement du dispositif de pulvérisation ionique basé sur le rapport des valeurs équivalentes mesurées par le dispositif de mesure de particules pulvérisées de manière ionique (1, 100, 200, 300), selon l'une des revendications 1-6.

8. Méthode de mesure de particules pulvérisées de manière ionique, comprenant :
une phase de mesure pour mesurer un rapport entre une valeur équivalente du nombre de particules d'ions déchargées par un objectif (12) à travers pulvérisation ionique causée par une décharge électrique impulsée et une valeur équivalente du nombre de particules neutres déchargées par l'objectif (12) à travers la pulvérisation ionique causée par la décharge électrique impulsée;
une phase d'ionisation pour ioniser les particules neutres déchargées par l'objectif (12) à travers la pulvérisation ionique ;
une phase de séparation de fréquence pour générer un signal de séparation de fréquence basé sur un signal à impulsions synchronisé avec l'apparition de la décharge électrique impulsée, le signal de séparation de fréquence possède une période qui est un multiple entier d'une période du signal à impulsions ;
une phase d'exécution pour exécuter la phase d'ionisation avec le signal de séparation de fréquence ; et
une phase de création du signal de séparation de fréquence à une première temporisation ;
où la décharge électrique impulsée est constituée d'une pluralité de décharges électriques impulsées successives, et où la phase de mesure sert à mesurer le rapport basé sur la valeur équivalente ou les valeurs équivalentes d'une ou des deux particules d'ions et les particules neutres déchargées par l'objectif à travers la pulvérisation ionique causée par la décharge électrique impulsée qui se produit à la première temporisation et en se basant sur la valeur équivalente ou les valeurs équivalentes d'une ou des deux particules d'ions et les particules neutres déchargées par l'objectif à travers la pulvérisation ionique causée par la décharge électrique impulsée qui se produit à une temporisation différente de la première temporisation.

9. Méthode de mesure de particules pulvérisées de manière ionique, comprenant :
une phase de mesure pour mesurer un rapport entre une valeur équivalente du nombre de particules d'ions déchargées par un objectif (12) à travers pulvérisation ionique causée par une décharge électrique impulsée et une valeur équivalente du nombre de particules neutres déchargées par l'objectif (12) à travers la pulvérisation ionique causée par la décharge électrique impulsée ;
une phase d'ionisation pour ioniser les particules neutres déchargées par l'objectif (12) à travers la pulvérisation ionique ;
une phase de séparation de fréquence pour générer un signal de séparation de fréquence basé sur un signal à impulsions synchronisé avec l'apparition de la décharge électrique impulsée, le signal de séparation de fréquence possède une période qui est un multiple entier d'une période du signal à impulsions;
une phase pour permettre ou empêcher l'ionisation des particules neutres dans la phase d'ionisation en se basant sur le signal de séparation de fréquence; et
une phase de création du signal de séparation de fréquence à une première temporisation ;
où la décharge électrique impulsée est constituée d'une pluralité de décharges électriques impulsées successives, et où la phase de mesure sert à mesurer le rapport basé sur la valeur équivalente ou les valeurs équivalentes d'une ou des deux particules d'ions et les particules neutres déchargées par l'objectif à travers la pulvérisation ionique causée par la décharge électrique impulsée qui se produit à la première temporisation et en se basant sur la valeur équivalente ou les valeurs équivalentes d'une ou des deux particules d'ions et les particules neutres déchargées par l'objectif à travers la pulvérisation ionique causée par la décharge électrique impulsée qui se produit à une temporisation différente de la première temporisation.

10. Méthode de mesure de particules pulvérisées de manière ionique, selon la revendication 8 ou 9, où le signal de séparation de fréquence possède une période qui est un multiple entier de la période du signal à impulsions et qui dépasse de deux à dix fois la valeur de la période du signal à impulsions.

11. Méthode de mesure de particules pulvérisées de manière ionique, selon une revendication quelconque de 8 à 10, comprenant en outre une phase d'élimination des particules d'ions pour éliminer les premières particules d'ions déchargées par l'objectif (12) à travers la pulvérisation ionique.

12. Méthode de mesure de particules pulvérisées de manière ionique, selon la revendication 11, comprenant en outre une phase de synchronisation de l'exécution de la phase d'ionisation et de l'exécution de la phase d'élimination de particules d'ions.

13. Méthode de mesure de particules pulvérisées de manière ionique, selon une revendication quelconque de 8 à 12, où la phase de mesure sert à mesurer les valeurs équivalentes du nombre de particules d'ions et des particules neutres à travers une spectrométrie de masse du temps de vol.

14. Méthode de pulvérisation ionique qui utilise la méthode de pulvérisation ionique à impulsions à puissance élevée, HIPIMS, comprenant :
une phase de contrôle pour contrôler, une ou les deux, une quantité de courant, une tension ou une énergie électrique pour la décharge pendant chaque décharge électrique impulsée du HIPIMS et une tension de polarisation appliquée à un travail comme objet de traitement de la méthode de pulvérisation ionique basée sur le rapport des valeurs équivalentes mesurées par la méthode de mesure de particules pulvérisées de manière ionique selon l'une des revendications de 8 à 13.
